(19) Europäisches Patentamt
European Patent Office
Office européen des brevets

(11) **EP 1 175 761 B1**

(12) **EUROPEAN PATENT SPECIFICATION**

(45) Date of publication and mention
of the grant of the patent:
**01.07.2009 Bulletin 2009/27**

(51) Int Cl.:
***H04L 27/26*** (2006.01)

(21) Application number: **00923456.8**

(86) International application number:
**PCT/US2000/010351**

(22) Date of filing: **18.04.2000**

(87) International publication number:
**WO 2000/064116 (26.10.2000 Gazette 2000/43)**

(54) **OFDM DEMODULATOR WITH PHASE CORRECTION OF THE I-Q SIGNALS**

OFDM DEMODULATOR MIT PHASENEINSTELLUNG DER I-Q SIGNALE

DEMODULATEUR POUR LE MULTIPLEXAGE FREQUENTIEL ORTHOGONAL ASSURANT UNE CORRECTION DE PHASE DES SIGNAUX I-Q

(84) Designated Contracting States:
**AT BE CH CY DE DK ES FI FR GB GR IE IT LI LU MC NL PT SE**

(30) Priority: **19.04.1999 GB 9908909**

(43) Date of publication of application:
**30.01.2002 Bulletin 2002/05**

(73) Proprietor: **NXP B.V.**
**5656 AG Eindhoven (NL)**

(72) Inventor: **Parker, Jonathan**
**Tower Hill,**
**Bristol BS2 0JA (GB)**

(74) Representative: **Williamson, Paul Lewis et al**
**NXP Semiconductors UK Ltd**
**Betchworth House**
**Station Road**
**Redhill**
**Surrey RH1 1DL (GB)**

(56) References cited:
**EP-A- 0 653 858**          **EP-A- 0 722 235**
**EP-A- 0 772 331**          **WO-A-99/12305**

## Description

### TECHNICAL FIELD OF THE INVENTION

This invention relates to receiver correction circuit, a receiver device, and to a method for processing a received signal in a radio frequency receiver. More specifically, the invention relates to the correction of nominal in-phase and quadrature received signals, in order to avoid errors which arise because those received signals are other than exactly orthogonal. In particular, the invention is described with reference to a digital terrestrial television demodulator.

However, the same correction technique could be used for any nominal in-phase and quadrature received signals, provided that, at the transmitter, the information contents on the in-phase and quadrature signals are not correlated, and provided that the signals are pseudo-random.

### BACKGROUND OF THE INVENTION

The European DVB-T (Digital Video Broadcasting - Terrestrial) standard for digital terrestrial television (DTT) uses Coded Orthogonal Frequency Division Multiplexing (COFDM) of transmitted signals.
A DVB-T receiver therefore typically includes an analog tuner for receiving the signals and downconverting to an intermediate frequency, an analog-digital converter, a digital demodulator, and a MPEG coder for producing output video signals. It will be realised that, although these different stages have been described, there can be overlap between the stages, and some or all functions can advantageously be combined onto a single chip.

In EP-A-0 653 858, an OFDM synchronization demodulation circuit is described, wherein, for obtaining carrier synchronization in an OFDM demodulator, delayed versions of an in-phase signal component and an orthogonal (quadrature) signal component of an OFDM modulated signal are generated and, then, correlation coefficients of the correlations between the non-delayed in-phase signal component and both the generated delayed in-phase , signal component and the generated delayed orthogonal phase signal component are calculated.

However, if an analog tuner is used to demodulate the signal into separate in-phase (I) and quadrature (Q) signals, then, typically, the generated I and Q signals are not always reliably separated by exactly 90° of phase, as they should be. When those signals are then used as the input to a demodulator, any phase imbalance can cause additional noise, due to crosstalk between the I and Q signals.

### SUMMARY OF THE INVENTION

This invention relates to a technique for correcting for any such imbalances and is described in the appended claims.

In particular, the invention relies on an appreciation that, if the phase difference between the received nominal in-phase and quadrature signals is anything other than exactly 90°, there will be a degree of correlation between the received signals. Moreover, the degree of correlation can be used as a measure of the amount of phase imbalance, allowing an appropriate correction to be applied so that the signals used for further processing are truly orthogonal.

According to the invention, there are therefore provided a signal processor, and a receiver, which apply a correction to a received signal, based on a phase imbalance estimated from a measured degree of correlation between nominal in-phase and quadrature signals.

### BRIEF DESCRIPTION OF DRAWINGS

Figure 1 is a block schematic diagram of a receiver device in accordance with the invention.

Figure 2 is a block schematic diagram of a pre-processing circuit forming part of the receiver device of Figure 1.

### DETAILED DESCRIPTION OF PREFERRED EMBODIMENTS

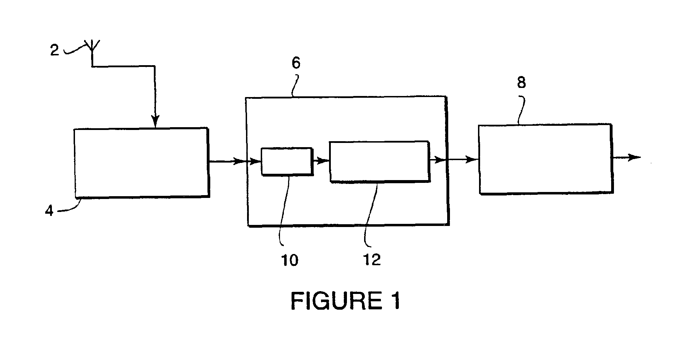

Figure 1 is block schematic diagram of a receiver device in accordance with the invention.

The invention is described herein with reference to its application in the reception of digital terrestrial television (DTT) signals using the European DVB-T standard based on Coded Orthogonal Frequency Division Multiplexing (COFDM), although it will be appreciated that its use is independent of the type of signals being received. Specifically, the invention can be applied to digital cable and digital television receivers using any suitable standard, and indeed any receiver for nominal in-phase and quadrature received signals, provided that, at the transmitter, the information contents on the in-phase and quadrature signals are not correlated, and provided that the signals are pseudo-random.

Figure 1 shows an antenna 2, for receiving broadcast signals, which are supplied to an analog tuner 4. The tuner 4 includes a mixer for downconversion of the received signals to a first intermediate frequency, and an analog-digital converter, and supplies input signals to the demodulator 6 in the form of digitised samples of the nominal received in-phase (I) and quadrature (Q) signals. The demodulator 6 then removes the COFDM modulation, and supplies output signals to a coder 8, which converts the digital signals into a form suitable for display, for example based on the MPEG-2 standard. The form of the coder is generally known to the person skilled in the art.

In accordance with the invention input signals received by the demodulator 6 are sent first to a pre-processor 10, which is described in detail below, and then to the demodulation circuitry 12. The form of the demodulation circuitry is generally known to the person skilled in the art.

Although Figure 1 shows several discrete blocks, it will be appreciated that the different stages may be integrated as far as is desirable, for example onto a single chip, or other arrangements of functions can be used. Moreover, the order of the stages can be selected as desired. For example, I and Q demodulation can take place in the analog domain or in the digital domain. Further, the A/D converter may be separate from the tuner.

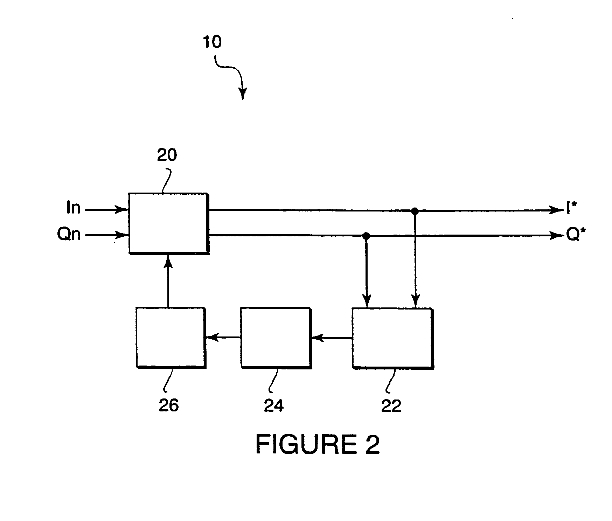

Figure 2 is a block schematic diagram of the pre-processing stage 10. Again, Figure 2 shows a number of discrete blocks, the functions of some or all of which may in fact be carried out together in, for example, a digital signal processor (DSP).

The pre-processing preferably takes the form of a feedback loop, in which a correction is applied to the input signals, and the corrected signals are then used to analyse the requirement for further correction.

The circuit receives digitised samples of the nominal in-phase and quadrature signals In, Qn respectively, received from the tuner 4. A correction for any detected phase imbalance is applied in a correction block 20, to give corrected in-phase and quadrature output signals I*, Q*, respectively.

These corrected signals are sampled, and fed to a correlation calculation block 22, which determines the degree of correlation between the corrected signals.

Since, ideally, the in-phase and quadrature signals should be separated by exactly 90° of phase, they should be completely orthogonal, that is, there should be no correlation between them. The correlation calculation block 22 can use any one of several known measures of correlation. However, in one embodiment of the invention, it uses the linear correlation coefficient or product-moment correlation coefficient, also known as Pearson's correlation coefficient. For each sample $x_i$, $y_i$ of the I and Q components (with the x values being samples from the I component signal, and y values being samples from the Q component signal), and with the mean values of x and y being $\bar{x}$ and $\bar{y}$ respectively, this coefficient, r, is defined as follows:-

$$r = \frac{\sum_i \left(x_i - \bar{x}\right)\left(y_i - \bar{y}\right)}{\sqrt{\sum_i \left(x_i - \bar{x}\right)^2}\sqrt{\sum_i \left(y_i - \bar{y}\right)^2}}$$

If the phase difference between the nominal in-phase and quadrature signals In and Qn is exactly 90°, as intended, the value of the correlation coefficient will tend, over a large enough number of signal samples, towards zero.

The measured value of the correlation coefficient is then supplied to block 24, which uses the measured correlation coefficient to obtain an estimate of the phase difference between the corrected in-phase and quadrature signals I* and Q*. Any variation of this phase difference from 90° is described as a phase imbalance. For example, block 24 may be a lookup table, in which the values of the coefficient corresponding to particular phase imbalances are stored.

Since it is believed that the relationship between phase imbalance and correlation coefficient is substantially linear, block 24 may simply apply a scaling factor to the measured correlation coefficient to obtain an estimate of the phase imbalance.

The phase imbalance estimate is then supplied to a loop filter 26, which forms a stable estimate of the mean phase imbalance, which is then supplied to the correction block 20.

Where it is desired simply to apply a scaling factor to the measured correlation coefficient to obtain the estimated phase imbalance, this scaling factor may in fact be applied through the loop filter 26 without requiring a separate conversion block 24.

The required form of the correction can be illustrated by defining the required uncorrelated input signals applied to the inphase and quadrature components as A and B respectively. If the recovered I axis is then assumed to be unaffected, but the recovered Q axis is not exactly perpendicular thereto, but rather is at $(90+\varphi)°$ thereto, the recovered Q axis is rotated by $\varphi°$ with respect to the transmit Q axis. The signal on the recovered Q axis is then given by:

$$Q_{rx} = A\cos\varphi + B\sin\varphi$$

which can be solved to obtain the required value of B because we know the value of A from the received I signal, and $\varphi$ is the calculated phase imbalance. This correction can then be applied to the received nominal quadrature input signal Qn, to obtain the corrected quadrature signal Q*.

This correction is of lower accuracy if there is also gain imbalance in the tuner, or elsewhere, that is, if the nominal in-phase and quadrature signals In, Qn have been subject to slightly different gains. Specifically, the relationship between the phase imbalance and the correlation co-efficient may not be directly proportional in the event of a gain imbalance. The relationship may still be substantially linear, but not passing through the origin.

Preferably, therefore, the pre-processor 10 also applies a gain correction to the nominal in-phase and quadrature signals In, Qn. More specifically, the variance of In and Qn can be estimated from individual samples thereof. Any difference between the variances can be taken to indicate a gain imbalance, and this can then be used to apply a correction to the measured correlation coefficient before this is used to estimate the phase imbalance. Alternatively, automatic gain control circuits may be used to remove any gain imbalance between the nominal in-phase and quadrature signals before the correlation coefficient is calculated.

After correction of the in-phase and quadrature components, the corrected components I*, Q* can then be used in further processing stages of the demodulator.

There is thus disclosed a system for removing noise components caused by phase imbalance resulting from the action of the tuner.

**Claims**

1. A receiver correction circuit (10), comprising:

   an input for receiving detected in-phase (In) and quadrature (Qn) signal components; and
   a phase estimator (24), for estimating a degree of phase correlation between the detected in-phase and quadrature signal components,
   the receiver correction circuit being **characterized in that** it further comprises:

   a phase correction circuit (20), for applying to at least one of said detected in-phase and quadrature signal components a correction factor, to minimize the degree of correlation between them.

2. A receiver correction circuit (10) as claimed in claimed 1, further comprising a feedback loop, wherein the phase estimator (22, 24) estimates the degree of correlation between the detected in-phase and quadrature signal components after application of the correction factor thereto.

3. A receiver correction circuit (10) as claimed in claims 1 or 2, wherein the phase estimator (22, 24) estimates a phase imbalance from the estimated degree of correlation between the detected in-phase and quadrature signal components.

4. A receiver correction circuit (10) as claimed in claim 1, further comprising:

   a correlation calculation circuit (22), coupled to the phase correction circuit (20); and
   a loop filter (26), coupled to the phase estimator (24), wherein the loop filter generates a stable estimate of a mean phase imbalance between the corrected I and Q signals;

   wherein the phase correction circuit (20) of the receiver correction circuit includes a phase imbalance detector for detecting phase imbalance between the received I and Q signals and is adapted for receiving digitized samples of in-phase (I) and quadrature (Q) signals and generating corrected I and Q signals based upon the detected phase imbalance in the received I and Q signals;
   wherein the phase estimator (24) is coupled to the correlation calculation circuit (22) and estimates a phase difference between the correlated I and Q signals; and
   wherein the correlation calculation circuit (22) determines a degree of correlation between the corrected I and Q signals.

5. A receiver correction circuit (10) as defined in Claim 4, wherein the receiver correction circuit (10) is configured in a closed-loop configuration wherein the loop filter (26) is coupled to the phase correction circuit (20), and wherein the phase correction circuit (20) estimates the degree of correlation between the corrected I and Q signals after applying a correction factor thereto.

6. A receiver correction circuit (10) as defined in Claim 4, wherein the phase estimator (24) includes a look-up table, and wherein the look-up table includes a plurality of correlation coefficients, each correlation coefficient having an associated and corresponding unique phase imbalance value.

7. A receiver correction circuit (10) as defined in Claim 4, wherein a scaling factor is applied through the loop filter (26), and wherein the phase estimator (24) is bypassed.

8. A receiver correction circuit (10) as defined in Claim 4, wherein the correlation calculation circuit (22) uses a linear correlation coefficient in determining the degree of correlation between the corrected I and Q signals.

9. A receiver correction circuit (10) as defined in Claim 8, wherein the linear correlation coefficient is represented by the variable r and is determined for each sample $x_i$, $y_i$ of the corrected I and Q signals, respectively, and wherein mean values of the $x_i$, $y_i$ samples are represented by $\bar{x}$ and $\bar{y}$, respectively, and wherein the coefficient, r, is calculated in accordance with the following equation:

$$r = \frac{\sum_i (x_i - \bar{x})(y_i - \bar{y})}{\sqrt{\sum_i (x_i - \bar{x})^2} \sqrt{\sum_i (y_i - \bar{y})^2}} \ .$$

10. A receiver device, comprising:

a tuner circuit (4), including an analog-digital converter and a downconverter, for forming in-phase and quadrature signal components; and a receiver correction circuit (10) as claimed in any preceding claim.

11. A receiver device as claimed in claim 10, further comprising an OFDM demodulator (6).

12. A receiver device as defined in Claim 11, further including a coder (8) coupled to the demodulator (6), wherein the coder (8) converts the corrected I and Q signals into a format suitable for display thereof.

13. A receiver device as defined in Claim 12, wherein the format is compatible with an MPEG-2 standard.

14. A receiver device as defined in Claim 10, wherein the receiver device comprises a digital terrestrial television receiver.

15. A receiver device as defined in Claim 10, wherein the selected modulation scheme comprises a Coded Orthogonal Frequency Division Multiplexing (COFDM) modulation scheme.

16. A method of processing a received signal in a radio frequency receiver, the method comprising:

   receiving detected in-phase and quadrature signal components; and
   estimating a degree of phase correlation between the detected in-phase and quadrature signal components,
   the method being **characterized in that** it further comprises:

   applying to at least one of said detected in-phase and quadrature signal components a phase correction factor, to minimize the degree of correlation between them.

17. A method as claimed in claim 16, wherein the degree of phase correlation between the detected in-phase and quadrature signal components is estimated after application of the phase correction factor thereto.

18. A method as claimed in claims 16 or 17, wherein a phase imbalance is estimated from the degree of phase correlation between the detected in-phase and quadrature signal components.

19. A method as claimed in claim 16, further comprising receiving transmitted signals and applying them to an analog-digital converter, and downconverting them to form in-phase and quadrature signal components.

20. A method as defined in Claim 16, wherein the degree of phase correlation between the in-phase and quadrature signal components is estimated by calculating a phase correlation coefficient between the in-phase and quadrature signals.

21. A method as defined in Claim 20, wherein the relationship between the phase correlation coefficient and the phase imbalance is empirically determined.

22. A method as defing in Claim 21, wherein the phase correlation coefficient is Pearson's correlation coefficient, and wherein the calculation of the phase correlation is implemented using an IIR filter.

23. A method as defined in Claim 16, wherein the radio frequency receiver is a digital television/cable receiver.

24. A method as defined in Claim 23, wherein the digital television/cable receiver uses a Coded Orthogonal Frequency Division Multiplexing (COFDM) modulation scheme.

25. A method as defined in Claim 16, further comprising:

   estimating a phase difference between the corrected I and Q signals; and
   generating a stable estimate of a mean phase imbalance between the corrected I and Q signals.

**Patentansprüche**

1. Empfängerkorrekturschaltkreis (10), umfassend:

   einen Eingang zum Empfangen von detektierten In-Phase-(In)- und Quadratur-(Qn)-Signalkomponenten, und
   einen Phasenschätzer (24) zum Schätzen eines Grades an Phasenkorrelation zwischen den detektierten In-Phase- und Quadratur-Signalkomponenten,

   wobei der Empfängerkorrekturschaltkreis **dadurch gekennzeichnet ist, dass** er ferner umfasst:

   einen Phasenkorrekturschaltkreis (20) zum Anwenden eines Korrekturfaktors auf wenigstens eine der detektierten In-Phase- und Quadratur-Signalkomponenten, um den Korrelationsgrad zwischen diesen zu minimieren.

2. Empfängerkorrekturschaltkreis (10) nach Anspruch 1, der ferner eine Rückführschleife umfasst, wobei der Phasenschätzer (22, 24) den Korrelationsgrad zwischen den detektierten In-Phase- und Quadratur-Signalkomponenten nach dem Anwenden des Korrekturfaktors darauf schätzt.

3. Empfängerkorrekturschaltkreis (10) nach Anspruch 1 oder 2, wobei der Phasenschätzer (22, 24) ein Phasenungleichgewicht ausgehend von dem geschätzten Korrelationsgrad zwischen den detektierten In-Phase- und Quadratur-Signalkomponenten schätzt.

4. Empfängerkorrekturschaltkreis (10) nach Anspruch 1, ferner umfassend:

    einen Korrelationsberechnungsschaltkreis (22), der mit dem Phasenkorrekturschaltkreis (20) gekoppelt ist; und
    ein Schleifenfilter (26), das mit dem Phasenschätzer (24) gekoppelt ist, wobei das Schleifenfilter eine stabile Schätzung eines mittleren Phasenungleichgewichts zwischen den korrigierten I- und Q-Signalen erzeugt,

    wobei der Phasenkorrekturschaltkreis (20) des Empfängerkorrekturschaltkreises einen Phasenungleichgewichtsdetektor zum Detektieren eines Phasenungleichgewichts zwischen den empfangenen I- und Q-Signalen enthält und eingerichtet ist zum Empfangen digitalisierter Abtastwerte von In-Phase-(I)- und Quadratur-(Q)-Signalen und zum Erzeugen von korrigierten 1- und Q-Signalen auf der Grundlage des detektierten Phasenungleichgewichts in den empfangenen 1- und Q-Signalen; wobei der Phasenschätzer (24) mit dem Korrelationsberechnungsschaltkreis (22) gekoppelt ist und eine Phasendifferenz zwischen den korrelierten I- und Q-Signalen schätzt; und wobei der Korrelationsberechnungsschaltkreis (22) einen Korrelationsgrad zwischen den korrigierten I- und Q-Signalen bestimmt.

5. Empfängerkorrekturschaltkreis (10) nach Anspruch 4, wobei der Empfängerkorrekturschaltkreis (10) in einer Regelkreis-Konfiguration konfiguriert ist, in der das Schleifenfilter (26) mit dem Phasenkorrekturschaltkreis (20) gekoppelt ist, und wobei der Phasenkorrekturschaltkreis (20) den Korrelationsgrad zwischen den korrigierten I- und Q-Signalen nach dem Anwenden eines Korrekturfaktors darauf schätzt.

6. Empfängerkorrekturschaltkreis (10) nach Anspruch 4, wobei der Phasenschätzer (24) eine Nachschlagetabelle enthält, wobei die Nachschlagetabelle eine Vielzahl von Korrelationskoeffizienten enthält, und wobei jeder Korrelationskoeffizient einen zugeordneten und entsprechenden eindeutigen Phasenungleichgewichtswert aufweist.

7. Empfängerkorrekturschaltkreis (10) nach Anspruch 4, wobei ein Skalierungsfaktor durch das Schleifenfilter (26) angewendet wird, und wobei der Phasenschätzer (24) umgangen wird.

8. Empfängerkorrekturschaltkreis (10) nach Anspruch 4, wobei der Korrelationsberechnungsschaltkreis (22) beim Bestimmen des Korrelationsgrades zwischen den korrigierten I- und Q-Signalen einen linearen Korrelationskoeffizienten verwendet.

9. Empfängerkorrekturschaltkreis (10) nach Anspruch 8, wobei der lineare Korrelationskoeffizient durch die Variable r repräsentiert wird und für jeden Abtastwert $x_i$, $y_i$ der korrigierten 1- bzw. Q-Signale ermittelt wird, und wobei Mittelwerte der Abtastwerte $x_i$, $y_i$ durch $\overline{x}$ beziehungsweise $\overline{y}$ repräsentiert werden, und wobei der Koeffizient r gemäß der folgenden Gleichung berechnet wird:

$$r = \frac{\sum_i (x_i - \overline{x})(y_i - \overline{y})}{\sqrt{\sum_i (x_i - \overline{x})^2} \sqrt{\sum_i (y_i - \overline{y})^2}} \; .$$

10. Empfängervorrichtung, umfassend:

    einen Abstimmschaltkreis (4), der einen Analog-Digital-Wandler und einen Abwärtswandler enthält, um In-Phase- und Quadratur-Signalkomponenten zu bilden, und
    einen Empfängerkorrekturschaltkreis (10) nach irgendeinem der vorangehenden Ansprüche.

11. Empfängervorrichtung nach Anspruch 10, die ferner einen OFDM-Demodulator (6) umfasst.

12. Empfängervorrichtung nach Anspruch 11, die ferner einen Codierer (8) enthält, der mit dem Demodulator (6) gekoppelt ist, wobei der Codierer (8) die korrigierten I- und Q-Signale in ein Format konvertiert, das zum Anzeigen derselben geeignet ist.

13. Empfängervorrichtung nach Anspruch 12, wobei das Format mit einem MPEG-2-Standard kompatibel ist.

14. Empfängervorrichtung nach Anspruch 10, wobei die Empfängervorrichtung einen digitalen terrestrischen Fernsehempfänger umfasst.

15. Empfängervorrichtung nach Anspruch 10, wobei das ausgewählte Modulationsschema ein Codierungs-Orthogonal- Frequenzmultiplex-(COFDM)-Modulationsschema umfasst.

16. Verfahren zum Verarbeiten eines empfangenen Signals in einem Hochfrequenzempfänger, wobei das Verfahren umfasst:

Empfangen von detektierten In-Phase- und Quadratur-Signalkomponenten; und Schätzen eines Grades an Phasenkorrelation zwischen den detektierten In-Phase- und Quadratur-Signalkomponenten,

wobei das Verfahren **dadurch gekennzeichnet ist, dass** es ferner umfasst:

Anwenden eines Phasenkorrekturfaktors auf wenigstens eine der detektierten In-Phase- und Quadratur-Signalkomponenten, um den Korrelationsgrad zwischen diesen zu minimieren.

**17.** Verfahren nach Anspruch 16, wobei der Grad an Phasenkorrelation zwischen den detektierten In-Phase- und Quadratur-Signalkomponenten nach dem Anwenden des Phasenkorrekturfaktors darauf geschätzt wird.

**18.** Verfahren nach Anspruch 16 oder 17, wobei ein Phasenungleichgewicht ausgehend von dem Grad an Phasenkorrelation zwischen den detektierten In-Phase- und Quadratur-Signalkomponenten geschätzt wird.

**19.** Verfahren nach Anspruch 16, das ferner das Empfangen von übermittelten Signalen und das Anlegen derselben an einen Analog-Digital-Wandler, sowie das Abwärtskonvertieren derselben, um In-Phase- und Quadratur-Signalkomponenten zu bilden, aufweist.

**20.** Verfahren nach Anspruch 16, wobei der Grad an Phasenkorrelation zwischen den In-Phase- und Quadratur-Signalkomponenten geschätzt wird, indem ein Phasenkorrelationskoeffizient zwischen den In-Phase- und Quadratur-Signalen berechnet wird.

**21.** Verfahren nach Anspruch 20, wobei die Beziehung zwischen dem Phasenkorrelationskoeffizienten und dem Phasenungleichgewicht empirisch bestimmt wird.

**22.** Verfahren nach Anspruch 21, wobei der Phasenkorrelationskoeffizient ein Pearson-Korrelationskoeffizient ist, und wobei die Berechnung der Phasenkorrelation unter Verwendung eines IIR-Filters implementiert ist.

**23.** Verfahren nach Anspruch 16, wobei der Hochfrequenz-Empfänger ein digitaler Fernseh-/Kabelempfänger ist.

**24.** Verfahren nach Anspruch 23, wobei der digitale Fernseh-/Kabelempfänger ein Codierungs-Orthogonal- Frequenzmultiplex-(COFDM)-Modulationsschema verwendet.

**25.** Verfahren nach Anspruch 16, ferner umfassend:

Schätzen einer Phasendifferenz zwischen den korrigierten I- und Q-Signalen; und Erzeugen einer stabilen Schätzung eines mittleren Phasenungleichgewichts zwischen den korrigierten I- und Q-Signalen.

## Revendications

**1.** Circuit de correction de récepteur (10), comprenant :

une entrée pour recevoir des composantes de signaux détectées en phase (In) et en quadrature (Qn) ; et un estimateur de phase (24), permettant d'estimer un degré de corrélation de phase entre les composantes de signaux détectées en phase et en quadrature, le circuit de correction de récepteur étant **caractérisé en ce qu'**il comprend, de plus :

un circuit de correction de phase (20) pour appliquer à au moins l'une desdites composantes de signaux détectées en phase et en quadrature un facteur de correction afin de minimiser le degré de corrélation entre-elles.

**2.** Circuit de correction de récepteur (10) selon la revendication 1, comprenant, de plus, une boucle de réaction, dans lequel l'estimateur de phase (22, 24) estime le degré de corrélation entre les composantes de signaux détectées en phase et en quadrature après application à celles-ci du facteur de correction.

**3.** Circuit de correction de récepteur (10) selon les revendications 1 ou 2, dans lequel l'estimateur de phase (22, 24) estime un déséquilibre de phase à partir du degré estimé de corrélation entre les composantes de signaux détectées en phase et en quadrature.

**4.** Circuit de correction de récepteur (10) selon la revendication 1, comprenant, de plus :

un circuit de calcul de corrélation (22), couplé au circuit de correction de phase (20) ; et un filtre de boucle (26), couplé à l'estimateur de phase (24), dans lequel le filtre de boucle génère une estimation stable d'un déséquilibre moyen de phase entre les signaux corrigés I et Q ;

dans lequel le circuit de correction de phase (20) du circuit de correction de récepteur comporte un détecteur de déséquilibre de phase pour détecter un déséquilibre de phase entre les signaux I et Q reçus et est adapté pour recevoir des échantillons numérisés de signaux en phase (I) et en quadrature (Q) et pour générer des signaux corrigés I et Q sur la base du déséquilibre de phase détecté dans les signaux I et Q reçus ;

dans lequel l'estimateur de phase (24) est couplé au circuit de calcul de corrélation (22) et estime une différence de phase entre les signaux corrélés I et Q ; et

dans lequel le circuit de calcul de corrélation (22) détermine un degré de corrélation entre les signaux corrigés I et Q.

5. Circuit de correction de récepteur (10) selon la revendication 4, dans lequel le circuit de correction de récepteur (10) est configuré suivant une configuration en boucle fermée dans laquelle le filtre de boucle (26) est couplé au circuit de correction de phase (20), et dans lequel le circuit de correction de phase (20) estime le degré de corrélation entre les signaux I et Q corrigés après leur avoir appliqué un facteur de correction.

6. Circuit de correction de récepteur (10) selon la revendication 4, dans lequel l'estimateur de phase (24) comporte une table de consultation, et dans lequel la table de consultation comporte une pluralité de coefficients de corrélation, chaque coefficient de corrélation ayant une valeur de déséquilibre de phase unique correspondante et associée.

7. Circuit de correction de récepteur (10) selon la revendication 4, dans lequel un facteur de conversion est appliqué à travers le filtre de boucle (26) et dans lequel l'estimateur de phase (24) est contourné.

8. Circuit de correction de récepteur (10) selon, la revendication 4, dans lequel le circuit de calcul de corrélation (22) utilise un coefficient de corrélation linaire dans la détermination du degré de corrélation entre les signaux I et Q corrigés.

9. Circuit de correction de récepteur (10) selon la revendication 8, dans lequel le coefficient de corrélation linéaire est représenté par la variable r et est déterminé pour chaque échantillon $x_i$, $y_i$ des signaux corrigés I et Q, respectivement, et dans lequel des valeurs moyennes des échantillons $x_i$, $y_i$ sont représentées par $\bar{x}$ et $\bar{y}$ respectivement, et dans lequel le coefficient r est calculé selon l'équation suivante :

$$ r = \frac{\sum_i (x_i - \bar{x})(y_i - \bar{y})}{\sqrt{\sum_i (x_i - \bar{x})^2} \sqrt{\sum_i (y_i - \bar{y})^2}} . $$

10. Dispositif récepteur, comportant :

un circuit de dispositif d'accord(4), incluant un convertisseur analogique - numérique et un dispositif de transposition par abaissement de fréquence, pour former des composantes de signaux en phase et en quadrature ; et
un circuit de correction de récepteur (10) selon l'une quelconque des revendications précédentes.

11. Dispositif récepteur selon la revendication 10, comprenant, de plus, un démodulateur pour multiplexage fréquentiel orthogonal (OFDM) (6).

12. Dispositif récepteur selon la revendication 11, comprenant, de plus, un codeur (8) couplé au démodulateur (6), dans lequel le codeur (8) convertit les signaux I et Q corrigés en un format approprié pour leur affichage.

13. Dispositif récepteur selon la revendication 12, dans lequel le format est compatible avec une norme de format vidéo numérisé MPEG-2.

14. Dispositif récepteur selon la revendication 10, dans lequel le dispositif récepteur comprend un récepteur de télévision terrestre numérique.

15. Dispositif récepteur selon la revendication 10, dans lequel le schéma de modulation sélectionné comporte un schéma de modulation à Multiplexage Fréquentiel Orthogonal Codé (COFDM).

16. Procédé de traitement d'un signal reçu dans récepteur de fréquences radio, le procédé consistant à :

recevoir des composantes de signaux détectées en phase et en quadrature ; et
estimer un degré de corrélation de phase entre les composantes de signaux détectées en phase et en quadrature,
le procédé étant **caractérisé en ce qu'**il consiste, de plus, à :

appliquer à au moins l'une des composantes de signaux détectées en phase et en quadrature un facteur de correction de phase afin de minimiser le degré de corrélation entre elles.

**17.** Procédé selon la revendication 16, dans lequel le degré de corrélation de phase entre les composantes de signaux détectées en phase et en quadrature est estimé après leur avoir appliqué le facteur de correction.

**18.** Procédé selon les revendications 16 ou 17, dans lequel un déséquilibre de phase est estimé à partir du degré de corrélation de phase entre les composantes de signaux détectées en phase et en quadrature.

**19.** Procédé selon la revendication 16, consistant, de plus, à recevoir des signaux transmis et à les appliquer à un convertisseur analogique - numérique, et à un dispositif de transposition par abaissement de fréquence pour former des composantes de signaux en phase et en quadrature.

**20.** Procédé selon la revendication 16, dans lequel le degré de corrélation de phase entre les composantes de signaux en phase et en quadrature est estimé en calculant un coefficient de corrélation de phase entre les signaux en phase et en quadrature.

**21.** Procédé selon la revendication 20 dans lequel la relation entre le coefficient de corrélation de phase et le déséquilibre de phase est déterminé de façon empirique.

**22.** Procédé selon la revendication 21, dans lequel le coefficient de corrélation de phase est un coefficient de corrélation de Pearson, et dans lequel le calcul de la corrélation de phase est mis en oeuvre en utilisant un filtre à réponse impulsionnelle infinie (IIR).

**23.** Procédé selon la revendication 16, dans lequel le récepteur de fréquences radio est un récepteur par câble/télévision numérique.

**24.** Procédé selon la revendication 23, dans lequel le récepteur par câble/télévision numérique utilise un schéma de modulation à multiplexage fréquentiel orthogonal codé (COFDM).

**25.** Procédé selon la revendication 16, consistant, de plus, à :

estimer une différence de phase entre les signaux I et Q corrigés ; et
générer une estimation stable d'un déséquilibre de phase moyen entre les signaux I et Q corrigés.

FIGURE 1

10

20

In →

Qn →

I*

Q*

26    24    22

FIGURE 2

EP 1 175 761 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0653858 A